# EUROPEAN PATENT APPLICATION

(11) **EP 4 739 031 A1**
(43) Date of publication of application: **06.05.2026**
(21) Application number: 25201200.0
(22) Date of filing: 09.09.2025
(51) Int. Cl.: H10D 64/68, H10D 84/01, H10D 84/83

(54) **SEMICONDUCTOR DEVICE**

(30) Priority: 30.10.2024 KR 20240151412
(71) Applicant: Samsung Electronics Co., Ltd., Suwon-si, Gyeonggi-do 16677 (KR)
(72) Inventor: AHN, Deok Lae, 16677 Suwon-si (KR); SONG, Hee Chan, 16677 Suwon-si (KR); LEE, Dong Soo, 16677 Suwon-si (KR); KIM, Taek Jung, 16677 Suwon-si (KR); PARK, Sang Hun, 16677 Suwon-si (KR)
(74) Representative: Marks & Clerk LLP

(57) **Abstract**

The semiconductor device includes a substrate including an NMOS region and a PMOS region, a first transistor in the NMOS region, including a first gate stack and a first source/drain region adjacent to the first gate stack, and a second transistor in the PMOS region, including a second gate stack and a second source/drain region adjacent to the second gate stack. The first gate stack includes a first high dielectric constant insulating film, an insertion layer, a first metal layer and a first protection layer that are sequentially stacked. The second gate stack includes a second high dielectric constant insulating film, a second metal layer and a second protection layer that are sequentially stacked. An oxygen concentration of the first protection layer is higher than an oxygen concentration of the first metal layer, and an oxygen concentration of the second protection layer is higher than an oxygen concentration of the second metal layer.

## Description

### TECHNICAL FIELD

The present disclosure relates to a semiconductor device.

### BACKGROUND

A semiconductor device such as a dynamic random access memory (DRAM) may include a cell array region and a peripheral region (i.e., a core-peri region). In particular, the peripheral region or the core-peri region may include a region in which a PMOS transistor is formed and a region in which an NMOS transistor is formed. Gate structures having different structures are disposed in the region in which the PMOS transistor is formed and the region in which the NMOS transistor is formed.

### BRIEF SUMMARY

The inventive concept of the present disclosure provides a semiconductor device capable of improving device performance and reliability.

The inventive concept of the present disclosure is not limited to the problems mentioned above and other problems to be solved by the technical idea of the present disclosure, which are not mentioned herein, will be clearly understood by those skilled in the art from the following description of the present disclosure.

According to an aspect of the present disclosure, there is provided a semiconductor device including, a substrate including an NMOS region and a PMOS region, a first transistor in the NMOS region, including a first gate stack and a first source/drain region, where the first source/drain region is adjacent to at least one side of the first gate stack, and a second transistor in the PMOS region, including a second gate stack and a second source/drain region, where the second source/drain region is adjacent to at least one side of the second gate stack, where the first gate stack includes a first high dielectric constant insulating film, an insertion layer, a first metal layer and a first protection layer that are sequentially stacked in a first direction, the second gate stack includes a second high dielectric constant insulating film, a second metal layer and a second protection layer that are sequentially stacked in the first direction, an oxygen concentration of the first protection layer is higher than an oxygen concentration of the first metal layer, and an oxygen concentration of the second protection layer is higher than an oxygen concentration of the second metal layer.

According to an aspect of the present disclosure, there is provided a semiconductor device including, a substrate including a cell array region and a peripheral region, where the cell array region includes a buried gate structure and the peripheral region includes an NMOS region and a PMOS region with different conductivity types, a first transistor in the NMOS region, including a first gate stack and a first source/drain region, where the first source/drain region is adjacent to at least one side of the first gate stack, and a second transistor in the PMOS region, including a second gate stack and a second source/drain region, where the second source/drain region is adjacent to at least one side of the second gate stack, where the first gate stack includes a first high dielectric constant insulating film, an insertion layer, a first metal layer and a first protection layer that are sequentially stacked in a first direction, the second gate stack includes a second high dielectric constant insulating film, a second metal layer and a second protection layer that are sequentially stacked in the first direction, an oxygen concentration of the first protection layer is higher than an oxygen concentration of the first metal layer, and an oxygen concentration of the second protection layer is higher than an oxygen concentration of the second metal layer.

According to an aspect of the present disclosure, there is provided a semiconductor device including, a substrate including an NMOS region and a PMOS region, a first transistor in the NMOS region, including a first gate stack and a first source/drain region, where the first source/drain region is adjacent to at least one side of the first gate stack, and a second transistor in the PMOS region, including a second gate stack and a second source/drain region, where the second source/drain region is adjacent to at least one side of the second gate stack, where the first gate stack includes a first high dielectric constant insulating film, an insertion layer, a first metal layer and a first protection layer that are sequentially stacked in a first direction, the second gate stack includes a second high dielectric constant insulating film, a second metal layer and a second protection layer that are sequentially stacked in the first direction, an oxygen concentration of the first protection layer is higher than an oxygen concentration of the first metal layer, an oxygen concentration of the second protection layer is higher than an oxygen concentration of the second metal layer, and a lanthanum (La) concentration in the first high dielectric constant insulating film is higher than a lanthanum (La) concentration in the second high dielectric constant insulating film.

It should be noted that the embodiments of the present disclosure are not limited to those described above, and other embodiments of the present disclosure will be clearly understood by those skilled in the art from the following description.

At least some of the above and other features of the invention are set out in the claims.

### BRIEF DESCRIPTION OF THE DRAWINGS

The above and other aspects of the present disclosure will become more apparent by describing in detail embodiments thereof with reference to the attached drawings, in which:
FIG. 1 is a cross-sectional view illustrating a semiconductor device according to some embodiments of the present disclosure,
FIG. 2 is a cross-sectional view illustrating a semiconductor device according to other embodiments of the present disclosure,
FIG. 3 is a plan view illustrating a semiconductor device according to some embodiments of the present disclosure,
FIG. 4 is a schematic enlarged layout view of the first region R1 of FIG. 3,
FIG. 5 is a cross-sectional view taken along lines A-A', B-B' and C-C' of FIG. 3, and
FIGS. 6, 7, 8, 9, 10, 11, 12, 13, and 14 are views illustrating intermediate steps to describe a method of manufacturing a semiconductor device according to some embodiments of the present disclosure.

### DETAILED DESCRIPTION

In the present disclosure, it will be understood that the terms "first", "second", "third" or the like used herein may describe various elements or components, regardless of the order and/or priority thereof, and is used only for distinguishing one element from another element, without limiting example embodiments. These elements or components should not be limited by these terms. These terms are only used to distinguish one element or component from another element or component, without limiting example embodiments. For example, a first element and a second element may be different entities, but may also be the same type of element, e.g., a first carbon portion and a second carbon portion are both the same type of element, i.e., carbon. Therefore, a first element or component discussed below could be termed a second element or component without departing from the scope of the present disclosure and likewise, a third direction DR3 may be termed a first direction.

The terminology used herein is for the purpose of describing particular embodiments and is not intended to limit the present disclosure. As used herein, the singular terms "a" and "an" are intended to include the plural terms as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. The term "at least one of" when preceding a list of elements may modify the entirety of list of elements and/or may not modify the individual elements of the list. When referring to "C to D", this means C inclusive to D inclusive unless otherwise specified. The term "on" as used herein, may refer to an element, component, or layer either directly or indirectly on a different element, component, or layer and encompassing physical and/or functional dependency. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

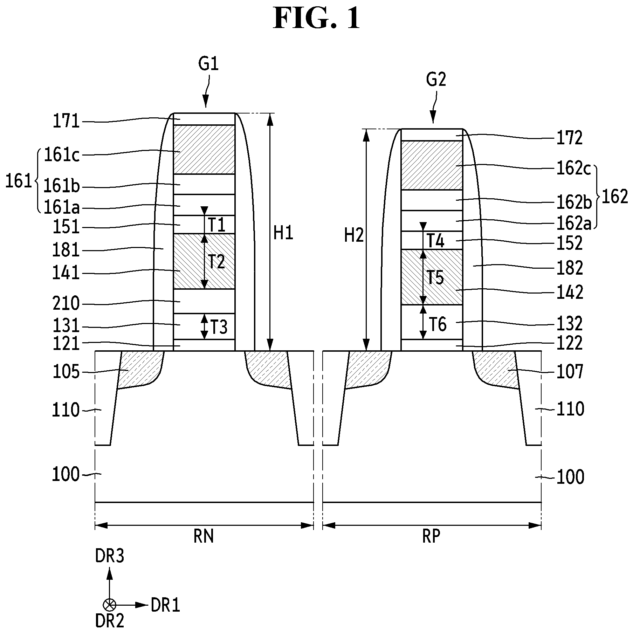

FIG. 1 is a cross-sectional view illustrating a semiconductor device according to some embodiments of the present disclosure.

Referring to FIG. 1, the semiconductor device according to some embodiments of the present disclosure may include a substrate 100, a first gate stack G1, a first gate spacer 181, a second gate stack G2, and a second gate spacer 182.

The substrate 100 may include an NMOS region RN and a PMOS region RP. The NMOS region RN and the PMOS region RP may be regions separated from each other or connected to each other. The term "connected" as used herein, refers to electrical and/or physical connection between elements or components and does not preclude the presence of additional elements or components therebetween.

Transistors having different conductivity types may be disposed in the NMOS region RN and the PMOS region RP, respectively. For example, an NMOS transistor may be formed in the NMOS region RN and a PMOS transistor may be formed in the PMOS region RP.

The substrate 100 may be, for example, bulk silicon or a silicon-on-insulator (SOI). The substrate 100 may be a silicon substrate or may include other materials, for example, silicon germanium, indium antimonide, lead telluride, indium arsenide, indium phosphide, gallium arsenide, and/or gallium antimonide. The substrate 100 may be an epitaxial layer formed on a base substrate.

The substrate 100 may include a device isolation film 110. A plurality of device isolation films 110 may be disposed in the substrate 100. The device isolation film 110 may be formed in the substrate 100 to define the NMOS region RN and the PMOS region RP, respectively. In addition, at least one transistor may be disposed between the device isolation films 110. The at least one transistor may be adjacent to each other, among (i.e. between) the device isolation films 110.

The device isolation film 110 may include silicon oxide, silicon nitride, and/or a combination thereof, but the technical scope of the present disclosure is not limited thereto. The device isolation film 110 may be a single layer made of (i.e. constituting, formed of, including) one type of insulating material, or may be a multi-layer made of (i.e. constituting, formed of, including) a combination of various types of insulating materials.

A first transistor may be disposed in the NMOS region RN. The first transistor may include a first gate stack G1, a first gate spacer 181, and a first source/drain region 105. The first transistor may be an n-type planar transistor.

The first gate spacer 181 may be disposed on at least one side of the first gate stack G1. For example, the first gate spacer 181 may be disposed on both sides of the first gate stack G1.

The first gate spacer 181 may include at least one of, for example, silicon nitride (SiN), silicon oxynitride (SiON), silicon oxide (SiO2), silicon oxycarbonitride (SiOCN), silicon carbon nitride (SiCN) and/or a combination thereof.

The first gate stack G1 may include a first interfacial insulating film 121, a first high dielectric constant insulating film 131, an insertion layer 210, a first metal layer 141, a first protection layer 151, a first conductive film structure 161 and a first hard mask pattern 171, which are sequentially laminated.

The first interfacial insulating film 121 may be disposed directly on the substrate. The first interfacial insulating film 121 may include, for example, a silicon oxide film and/or a silicon oxynitride film. The first high dielectric constant insulating film 131 may be disposed on the first interfacial insulating film 121. The first high dielectric constant insulating film 131 may include, for example, a high-k dielectric material having a dielectric constant higher than that of silicon oxide. The first high dielectric constant insulating film 131 may include, for example, hafnium oxide (HfO), hafnium silicate (HfSiO), hafnium oxide nitride (HfON), hafnium silicon oxide nitride (HfSiON), lanthanum oxide (LaO), lanthanum aluminum oxide (LaAlO), zirconium oxide (ZrO), zirconium silicate (ZrSiO), zirconium oxide nitride (ZrON), zirconium silicon oxide nitride (ZrSiON), tantalum oxide (TaO), titanium oxide (TiO), barium strontium titanium oxide (BaSrTiO), barium titanium oxide (BaTiO), strontium titanium oxide (SrTiO), yttrium oxide (YO), aluminum oxide (AlO), lead scandium tantalum oxide (PbScTaO), and/or a combination thereof, but the technical scope of the present disclosure is not limited thereto. For example, the first high dielectric constant insulating film 131 may not include lanthanum.

The insertion layer 210 may be disposed on the first high dielectric constant insulating film 131. The insertion layer 210 may include lanthanum. For example, the insertion layer 210 may include at least one of lanthanum and/or lanthanum oxide.

The first metal layer 141 may be disposed on the insertion layer 210. The first metal layer 141 may include at least one of, for example, titanium (Ti), aluminum (Al), tungsten (W), molybdenum (Mo) and/or lanthanum (La).

The first protection layer 151 may be disposed on the first metal layer 141. The first protection layer 151 may be disposed directly on the first metal layer 141, for example another layer may not be interposed between the first protection layer 151 and the first metal layer 141.

The first protection layer 151 may include an oxide or an oxynitride of metal included in the first metal layer 141. For example, when the first metal layer 141 includes titanium aluminum nitride (TiAlN), the first protection layer 151 may include titanium oxide (TiO).

A concentration of oxygen (O) contained in the first protection layer 151 is higher than a concentration of oxygen contained in the first metal layer 141. For reference, comparing the concentration of oxygen contained in the first protection layer 151 is also applied to even the case that oxygen is not contained in the first metal layer 141. That is, even in the case that the first metal layer 141 does not contain oxygen, the concentration of oxygen contained in the first protection layer 151 may be higher than the concentration of oxygen contained in the first metal layer 141. In other words, when the first metal layer 141 does not contain oxygen (i.e. the concentration of oxygen in the first metal layer 141 is effectively undetectable or negligible), it is still the case that the concentration of oxygen in the first protection layer 151 is higher than the concentration of oxygen in the first metal layer 141.

When the first protection layer 151 has an oxygen concentration higher than that of the first metal layer 141, oxygen may be prevented from flowing into the first metal layer 141 from the upper portion of the first protection layer 151. Accordingly, performance and reliability of the semiconductor device may be improved.

The first conductive film structure 161 may be disposed on an upper surface of the first protection layer 151. The first conductive film structure 161 may include a metal material. The first conductive film structure 161 may include a first lower conductive film 161a, a first insertion conductive film 161b, and a first upper conductive film 161c. The first lower conductive film 161a, the first insertion conductive film 161b and the first upper conductive film 161c may be sequentially stacked on the upper surface of the first protection layer 151. In other words, the first insertion conductive film 161b may be disposed between the first lower conductive film 161a and the first upper conductive film 161c.

The first lower conductive film 161a may include a conductive semiconductor material. The first lower conductive film 161a may include at least one of polysilicon, polysilicon germanium, polygermanium, amorphous silicon, amorphous silicon germanium and/or amorphous germanium. The first insertion conductive film 161b may include, for example, a metal silicide material. The first upper conductive film 161c may include at least one of, for example, tungsten, aluminum and/or copper. In some embodiments, each of the first lower conductive film 161a, the first insertion conductive film 161b, and the first upper conductive film 161c may include a plurality of film materials.

The first hard mask pattern 171 may be disposed on the first conductive film structure 161. The first hard mask pattern 171 may include silicon nitride or silicon oxide.

A second transistor (i.e., transistor) may be disposed in the PMOS region RP. The second transistor may include a second gate stack G2, a second gate spacer 182, and a second source/drain region 107. The second transistor may be a p-type planar transistor.

The second gate spacer 182 may be disposed on at least one side of the second gate stack G2. For example, the second gate spacer 182 may be disposed on both sides of the second gate stack G2.

The second gate spacer 182 may include at least one of, for example, silicon nitride (SiN), silicon oxynitride (SiON), silicon oxide (SiO2), silicon oxycarbonitride (SiOCN), silicon carbon nitride (SiCN) and/or a combination thereof.

The second gate stack G2 may include a second interfacial insulating film 122, a second high dielectric constant insulating film 132, a second metal layer 142, a second protection layer 152, a second conductive film structure 162 and a second hard mask pattern 172, which are sequentially stacked.

The second interfacial insulating film 122 may be disposed directly on the substrate. The second interfacial insulating film 122 may include, for example, a silicon oxide film or a silicon oxynitride film. The second high dielectric constant insulating film 132 may be disposed on the second interfacial insulating film 122. The second high dielectric constant insulating film 132 may include, for example, a high-k dielectric material having a dielectric constant higher than that of silicon oxide. The second high dielectric constant insulating film 132 may include, for example, hafnium oxide (HfO), hafnium silicate (HfSiO), hafnium oxide nitride (HfON), hafnium silicon oxide nitride (HfSiON), lanthanum oxide (LaO), lanthanum aluminum oxide (LaAlO), zirconium oxide (ZrO), zirconium silicate (ZrSiO), zirconium oxide nitride (ZrON), zirconium silicon oxide nitride (ZrSiON), tantalum oxide (TaO), titanium oxide (TiO), barium strontium titanium oxide (BaSrTiO), barium titanium oxide (BaTiO), strontium titanium oxide (SrTiO), yttrium oxide (YO), aluminum oxide (AlO), lead scandium tantalum oxide (PbScTaO), and/or a combination thereof, but the technical scope of the present disclosure is not limited thereto.

For example, when both the first high dielectric constant insulating film 131 and the second high dielectric constant insulating film 132 contain lanthanum, the concentration of lanthanum contained in the second high dielectric constant insulating film 132 may be higher than the concentration of lanthanum contained in the first high dielectric constant insulating film 131.

The second metal layer 142 may be disposed on the second high dielectric constant insulating film 132. The second metal layer 142 may include at least one of, for example, titanium (Ti), aluminum (Al), tungsten (W), molybdenum (Mo) and/or lanthanum (La). The second metal layer 142 may include the same metal material as that of the first metal layer 141.

The second protection layer 152 may be disposed on the second metal layer 142. The second protection layer 152 may be disposed directly on the second metal layer 142, for example. Therefore, in some embodiments, another layer may not be interposed between the second protection layer 152 and the second metal layer 142.

The second protection layer 152 may include an oxide or an oxynitride of metal contained in the second metal layer 142. For example, when the second metal layer 142 includes titanium aluminum nitride (TiAlN), the second protection layer 152 may include titanium oxide (TiO).

A concentration of oxygen (O) contained in the second protection layer 152 is higher than a concentration of oxygen contained in the second metal layer 142. For reference, comparing the concentration of oxygen contained in the second protection layer 152 is also applied to even the case that oxygen is not contained in the second metal layer 142. That is, even in the case that the second metal layer 142 does not contain oxygen, the concentration of oxygen contained in the second protection layer 152 may be expressed to be higher than the concentration of oxygen contained in the second metal layer 142. In other words, when the second metal layer 142 does not contain oxygen (i.e. the concentration of oxygen in the second metal layer 142 is effectively undetectable or negligible), it is still the case that the concentration of oxygen in the second protection layer 152 is higher than the concentration of oxygen in the second metal layer 142.

When the second protection layer 152 has an oxygen concentration higher than that of the second metal layer 142, oxygen may be prevented from flowing into the second metal layer 142 from the upper portion of the second protection layer 152. Accordingly, performance and reliability of the semiconductor device may be improved.

The second conductive film structure 162 may be disposed on an upper surface of the second protection layer 152. The second conductive film structure 162 may include a metal material. The second conductive film structure 162 may include a second lower conductive film 162a, a second insertion conductive film 162b, and a second upper conductive film 162c. The second lower conductive film 162a, the second insertion conductive film 162b and the second upper conductive film 162c may be sequentially stacked on the upper surface of the second protection layer 152. In other words, the second insertion conductive film 162b may be disposed between the second lower conductive film 162a and the second upper conductive film 162c.

The second lower conductive film 162a may include a conductive semiconductor material. The second lower conductive film 162a may include at least one of polysilicon, polysilicon germanium, polygermanium, amorphous silicon, amorphous silicon germanium and/or amorphous germanium. The second insertion conductive film 162b may include, for example, a metal silicide material. The second upper conductive film 162c may include at least one of, for example, tungsten, aluminum and/or copper. In some embodiments, each of the second lower conductive film 162a, the second insertion conductive film 162b, and the second upper conductive film 162c may include a plurality of film materials.

The second hard mask pattern 172 may be disposed on the second conductive film structure 162. The second hard mask pattern 172 may include silicon nitride or silicon oxide.

A height H1 of the first gate stack G1 in a third direction DR3 may be greater than a height H2 of the second gate stack G2 in the third direction DR3. For example, the height H1 of the first gate stack G1 in the third direction DR3 may be 10Å (i.e., 10 angstroms) greater than the height H2 of the second gate stack G2 in the third direction DR3, but is not limited thereto.

A thickness T1 of the first protection layer 151 in the third direction DR3 may be less than a thickness T2 of the first metal layer 141 in the third direction DR3. For example, the thickness T2 of the first metal layer 141 in the third direction DR3 may be three times (i.e. 3X) the thickness T1 of the first protection layer 151 in the third direction DR3. As used herein, the term "thickness" refers to a thickness in any respective direction. For example, a thickness T1 of the first protection layer 151 may refer to a thickness of the first protection layer in the third direction DR3.

The thickness T1 of the first protection layer 151 in the third direction DR3 may be the same as a thickness T4 of the second protection layer 152 in the third direction DR3. The thickness T2 of the first metal layer 141 in the third direction DR3 may be the same as a thickness T5 of the second metal layer 142 in the third direction DR3. A thickness T3 of the first high dielectric constant insulating film 131 in the third direction DR3 may be less than a thickness T6 of the second high dielectric constant insulating film 132 in the third direction DR3.

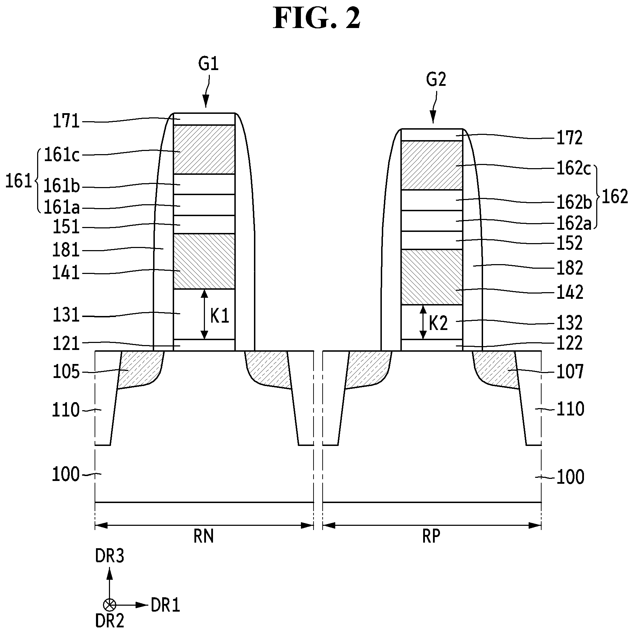

FIG. 2 is a cross-sectional view illustrating a semiconductor device according to other embodiments of the present disclosure. For convenience of description, the description of FIG. 2 will be based on differences from FIG. 1.

Referring to FIG. 2, the semiconductor device according to other embodiments of the present disclosure may include a substrate 100, a first gate stack G1, a first gate spacer 181, a second gate stack G2, and a second gate spacer 182.

The first gate stack G1 may include a first interfacial insulating film 121, a first high dielectric constant insulating film 131, a first metal layer 141, a first protection layer 151, a first conductive film structure 161, and a first hard mask pattern 171, which are sequentially stacked.

The first metal layer 141 may be disposed on the first high dielectric constant insulating film 131. The first metal layer 141 may be disposed, for example, directly on the first high dielectric constant insulating film 131. In some embodiments, another layer may not be interposed between the first high dielectric constant insulating film 131 and the first metal layer 141. A thickness K1 (e.g., T3) of the first high dielectric constant insulating film 131 in the third direction DR3 may be greater than a thickness K2 (e.g., T6) of the second high dielectric constant insulating film 132 in the third direction DR3.

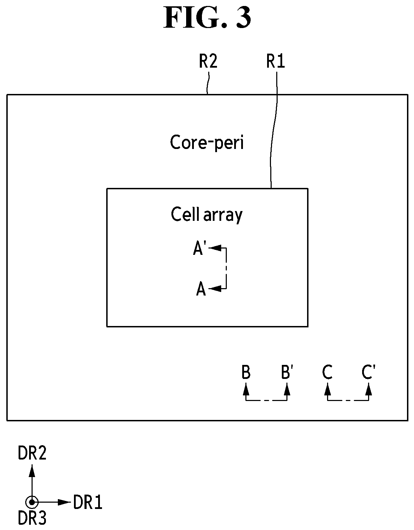

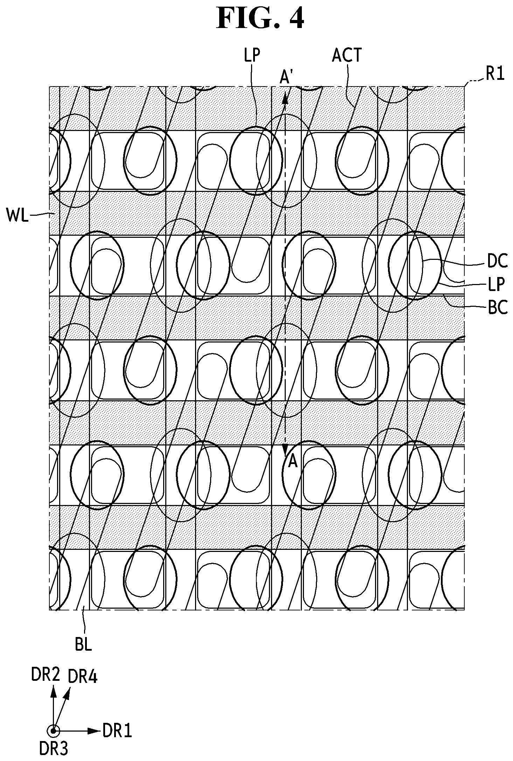

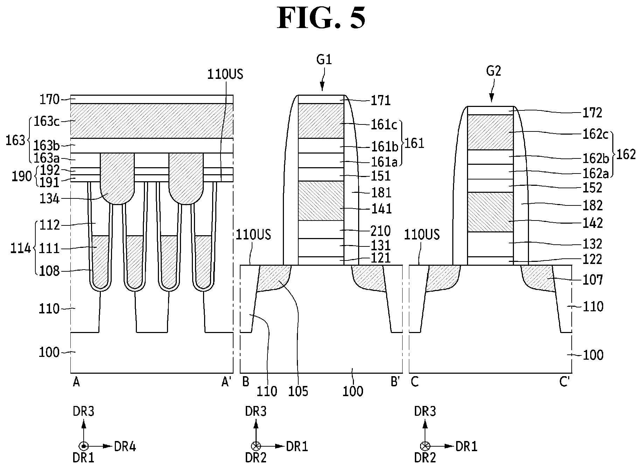

FIG. 3 is a plan view illustrating a semiconductor device according to some embodiments of the present disclosure. FIG. 4 is a schematic enlarged layout view of a first region R1 of FIG. 3. FIG. 5 is a cross-sectional view taken along lines A-A', B-B' and C-C' of FIG. 4. For convenience of description, description of FIGS. 3, 4, and 5 will be based on differences from FIG. 1.

For reference, a height of an upper surface 110US of the device isolation film 110 in a cross-sectional view of A-A' is shown to be different from a height of the upper surface 110US of the device isolation film 110 in a cross-sectional view of B-B' and a height of the upper surface 110US of the device isolation film 110 in a cross-sectional view of C-C', but this is only for convenience of description, without limiting example embodiments. That is, the height of the upper surface 110US of the device isolation film 110 in the cross-sectional view of A-A', the height of the upper surface 110US of the device isolation film 110 in the cross-sectional view of B-B', and the height of the upper surface 110US of the device isolation film 110 in the cross-sectional view of C-C' may all be the same height.

Referring to FIGS. 3, 4, and 5, the substrate 100 may include a first region R1 and a second region R2. The first region R1 may be surrounded by the second region R2. For example, the second region R2 may surround the first region R1 in a plan view of a horizontal plane formed by a first direction DR1 and a second direction DR2. The first region R1 may be a cell array region. The second region R2 may be a peripheral region or a core-peri region. The first region R1 may be a region where a memory cell of a memory device is arranged. The second region R2 may be a region where transistors, which surround a memory cell region and control an operation of the memory cell, are formed.

The first region R1 may include a word line WL, a bit line BL, a buried contact BC, a direct contact DC, and a landing pad LP. A plurality of buried gate structures 114 may be disposed on the substrate 100 of the first region R1. The plurality of buried gate structures 114 may be parallel to each other while being spaced apart from each other at a predetermined interval.

A plurality of gate electrodes extending in the first direction DR1 may be disposed across a cell active region ACT. The plurality of gate electrodes may extend parallel with each other. The plurality of gate electrodes may be, for example, a plurality of word lines WL. The word lines WL may be disposed at equal intervals. A width of the word line WL or an interval between the word lines WL may be determined depending on a design rule.

A plurality of bit lines BL orthogonal to the word line WL and extending in the second direction DR2 may be disposed on the word line WL. The plurality of bit lines BL may extend parallel with each other (i.e. extend in parallel with each other). The bit lines BL may be disposed at equal intervals. A width of the bit line BL or an interval between the bit lines BL may be determined depending on a design rule.

The semiconductor memory device according to some embodiments may include various contact arrangements formed on the cell active region ACT. For example, various contact arrangements may include a direct contact DC, a buried contact BC, and/or a landing pad LP.

In this case, the direct contact DC may mean a contact for electrically connecting the cell active region ACT to the bit line BL. The buried contact BC may mean a contact for connecting the cell active region ACT to a lower electrode of a data storage pattern. The contact area between the buried contact BC and the cell active region ACT may be small. Accordingly, to expand a contact area with the cell active region ACT and a contact area with the lower electrode, a conductive landing pad LP may be introduced.

The landing pad LP may be disposed between the cell active region ACT and the buried contact BC, or may be disposed between the buried contact BC and the lower electrode. As the contact area is expanded through the introduction of the landing pad LP, contact resistance between the cell active region ACT and a capacitor lower electrode may be reduced.

As the buried contact BC is disposed at both ends of the cell active region ACT, the landing pad LP may be disposed to partially overlap the buried contact BC by adjoining (i.e., physically or electrically connecting) both ends of the cell active region ACT.

The word line WL may be formed in a buried structure in the substrate 100. The word line WL may be disposed to cross the cell active region ACT between the direct contacts DC or the buried contacts BC. As shown, two word lines WL may be disposed to cross one cell active region ACT. The cell active region ACT extends along a fourth direction DR4 such that the word line WL may have an angle less than 90° with the cell active region ACT.

The direct contact DC and the buried contact BC may be symmetrically disposed. Accordingly, the direct contact DC and the buried contact BC may be disposed on a straight line along the first direction DR1 e.g. the direct contact DC and the buried contact BC may be arranged collinearly along the first direction DR1. The direct contact DC may be disposed symmetrically with respect to the straight line along the first direction DR1. The buried contact BC may be disposed symmetrically with respect to the straight line along the first direction DR1. The direct contact DC may be disposed symmetrically with respect to a straight line along the second direction DR2.

The landing pad LP may be disposed in a zigzag shape in the second direction DR2 in which the bit line BL extends. Also, the landing pad LP may be disposed to overlap the same side portion of each bit line BL in the first direction DR1 in which the word line WL extends.

For example, each of the landing pads LP of a first line of landing pads LP may overlap a left side of the corresponding bit line BL, and each of the landing pads LP of a second line of landing pads LP may overlap a right side of the corresponding bit line BL.

The buried gate structure 114 may include a buried gate insulating film 108, a buried gate electrode 111, and a buried mask pattern 112. The buried gate insulating film 108 may be disposed between the buried gate electrode 111 and the substrate 100, between the buried gate electrode 111 and the device isolation film 110, between the buried mask pattern 112 and the substrate 100, and between the buried mask pattern 112 and the device isolation film 110. The buried mask pattern 112 may be disposed on the buried gate electrode 111.

The buried gate insulating film 108 may include, for example, silicon oxide. The buried gate electrode 111 may include a metal material or a polysilicon material. The buried gate electrode 111 may have, for example, a stacked structure of a barrier metal film and a metal film. The buried mask pattern 112 may include, for example, a nitride film.

A contact plug 134 may be disposed on the buried mask pattern 112. The contact plug 134 may include, for example, a polysilicon material, but is not limited thereto.

An insulating film structure 190 including a plurality of insulating films may be disposed on the substrate 100 between the contact plugs 134. The insulating film structure 190 may include a first insulating film 191 and a second insulating film 192. The first insulating film 191 and the second insulating film 192 may include materials different from each other. Each of the first insulating film 191 and the second insulating film 192 may include silicon oxide, silicon oxynitride, or silicon nitride, but is not limited thereto. As another example, the insulating film structure 190 may be a structure that includes a single film.

A third conductive film structure 163 may be disposed on an upper surface of the second insulating film 192. The third conductive film structure 163 may include the same material as that of the first conductive film structure 161, and may have the same stacked structure as that of the first conductive film structure 161. That is, the third conductive film structure 163 may include a third lower conductive film 163a, a third insertion conductive film 163b and a third upper conductive film 163c, which are sequentially stacked. In other words, the third insertion conductive film 163b may be disposed between the third lower conductive film 163a and the third upper conductive film 163c. For reference, each of the first conductive film structure 161, the second conductive film structure 162 and the third conductive film structure 163 may correspond to the bit line BL of FIG. 4.

A third hard mask pattern 170 may be disposed on the third conductive film structure 163. The third hard mask pattern 170 may include the same material as that of the first hard mask pattern 171.

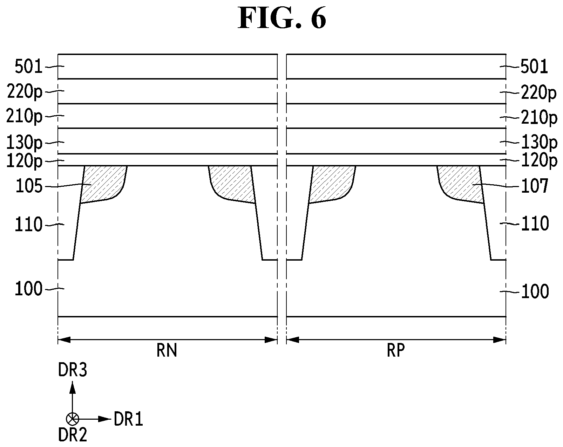

FIGS. 6, 7, 8, 9, 10, 11, 12, 13, and14 are views illustrating intermediate steps to describe a method of manufacturing a semiconductor device according to some embodiments of the present disclosure.

Referring to FIG. 6, a substrate 100 including a device isolation film 110, a first source/drain region 105 and a second source/drain region 107 may be provided. A pre-interfacial insulating film 120p, a pre-high dielectric constant insulating film 130p, a pre-insertion layer 210p, a pre-dummy layer 220p and a coating layer 501 may be sequentially stacked on the substrate 100.

The coating layer 501 may include, for example, a bottom anti-reflective coating (BARC) material. For example, BARC may be composed naphthalene-based or acrylic -based polymers, silicon dioxide (SiO₂), titanium oxide (TiOx), siloxane, or combinations thereof, but is not limited thereto.

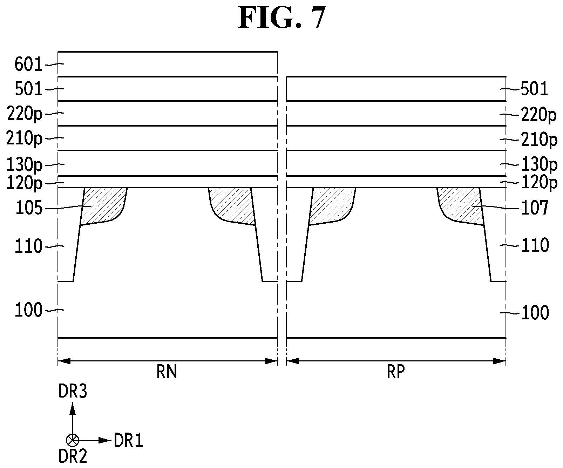

Referring to FIG. 7, a mask 601 may be formed on the coating layer 501 of the NMOS region RN. The mask 601 may be, for example, a photoresist (PR). The mask 601 is not formed in the PMOS region RP.

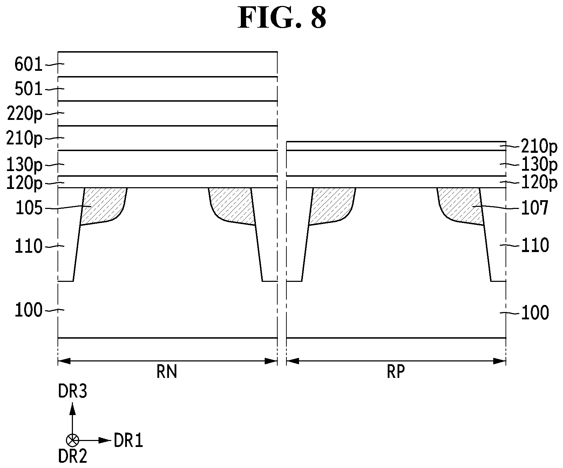

Referring to FIG. 8, portions of the coating layer 501, the pre-dummy layer 220p and the pre-insertion layer 210p of the PMOS region RP may be removed. Portions of the coating layer 501, the pre-dummy layer 220p and the pre-insertion layer 210p of the PMOS region RP may be removed using etching selectivity. The coating layer 501 and the pre-dummy layer 220p of the PMOS region RP may be completely removed. The pre-insertion layer 210p of the PMOS region RP is partially removed and partially remains.

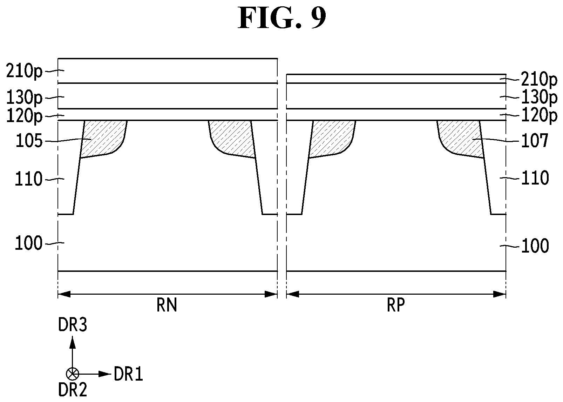

Referring to FIG. 9, the mask (e.g., 601 of FIG. 8), the coating layer 501 and the pre-dummy layer 220p of the NMOS region RN may be removed. The coating layer 501 and the pre-dummy layer 220p of the NMOS region RN may be completely removed.

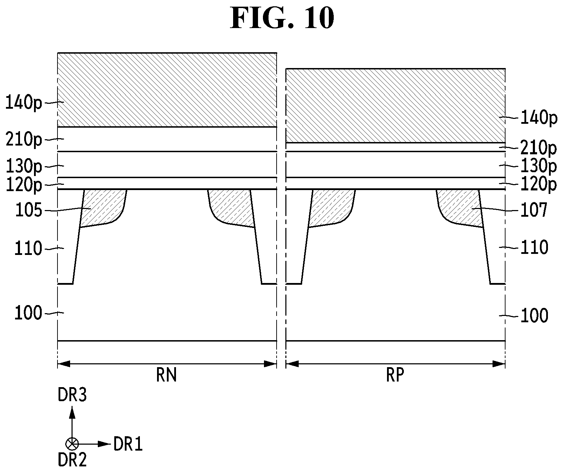

Referring to FIG. 10, a pre-metal layer 140p may be formed on the NMOS region RN and the PMOS region RP. The pre-metal layer 140p may be formed on the pre-insertion layer 210p of the NMOS region RN. The pre-metal layer 140p may be formed on the partially removed pre-insertion layer 210p of the PMOS region RP.

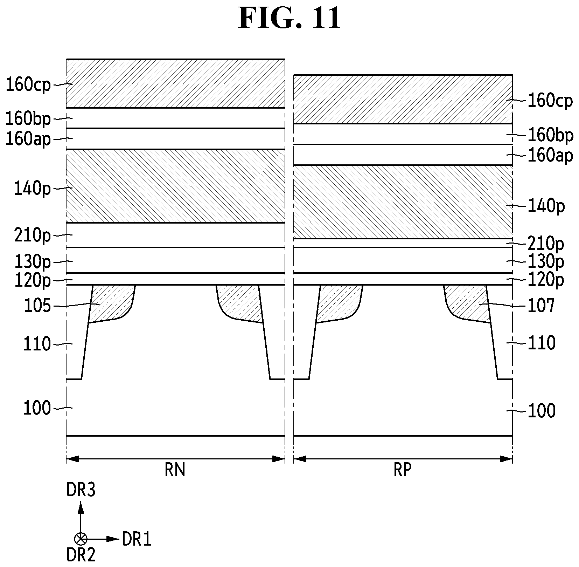

Referring to FIG. 11, a pre-lower conductive film 160ap, a pre-insertion conductive film 160bp and a pre-upper conductive film 160cp may be sequentially formed on the NMOS region RN and the PMOS region RP. In other words, the pre-lower conductive film 160ap, the pre-insertion conductive film 160bp and the pre-upper conductive film 160cp may be sequentially formed on the pre-metal layer 140p in the NMOS region RN, and the pre-lower conductive film 160ap, the pre-insertion conductive film 160bp and the pre-upper conductive film 160cp may be sequentially formed on the pre-metal layer 140p of the PMOS region RP.

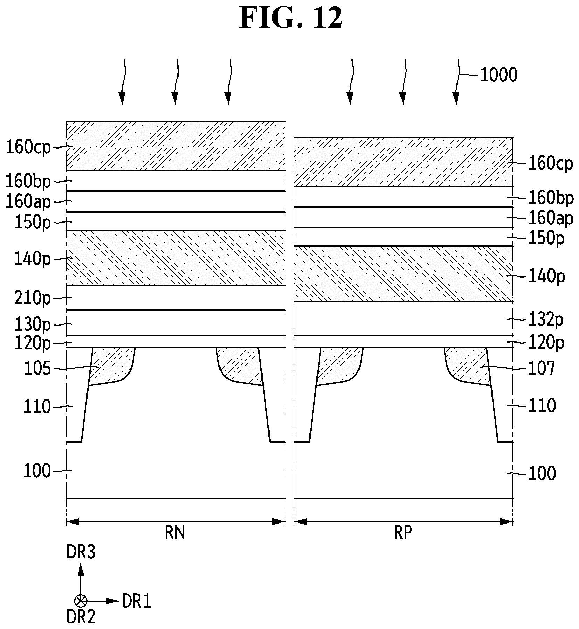

Subsequently, referring to FIG. 12, an annealing process 1000 may be performed on the NMOS region RN and the PMOS region RP. A pre-protection layer 150p may be formed on upper portions of the pre-metal layer 140p of the NMOS region RN and the PMOS region RP by the annealing process 1000. In other words, the pre-protection layer 150p may be formed between the pre-metal layer 140p and the pre-lower conductive film 160ap. The pre-protection layer 150p may include an oxide or an oxynitride formed from the pre-metal layer 140p by applying heat to the pre-metal layer 140p.

The pre-insertion layer (see 210p of FIG. 11) that remains without being completely removed from the PMOS region RP is diffused by the annealing process 1000 into the pre-high dielectric constant insulating film (see 130p of FIG. 11), so that a pre-second high dielectric constant insulating film 132p may be formed.

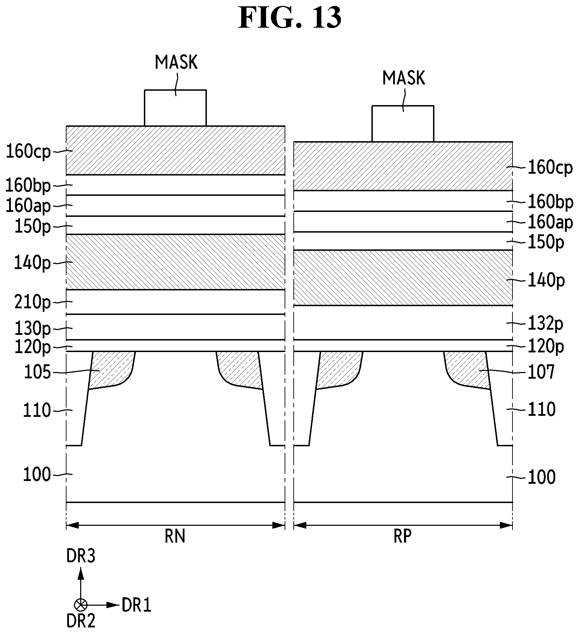

Referring to FIG. 13, a gate mask MASK may be formed on the pre-upper conductive film 160cp of the NMOS region RN and the PMOS region RP. The pre-interfacial insulating film 120p, the pre-high dielectric constant insulating film 130p, the pre-insertion layer 210p, the pre-metal layer 140p, the pre-protection layer 150p, the pre-lower conductive film 160ap, the pre-insertion conductive film 160bp and the pre-upper conductive film 160cp of the NMOS region RN, which are not covered by the gate mask MASK, may be removed. The pre-interfacial insulating film 120p, the pre-second high dielectric constant insulating film 132p, the pre-metal layer 140p, the pre-protection layer 150p, the pre-lower conductive film 160ap, the pre-insertion conductive film 160bp and the pre-upper conductive film 160cp of the PMOS region RP, which are not covered by the gate mask MASK, may be removed. The term "covered," or the like used herein may specify an element, component or layer that is partially or fully, on, surrounding, overlapping or encasing another element, component, or layer.

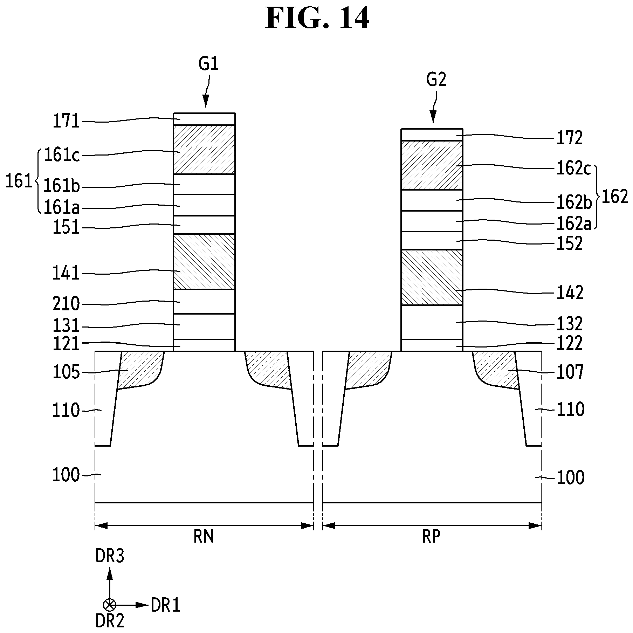

Referring to FIG. 14, a first gate stack G1 and a second gate stack G2 may be formed. The first gate stack G1 may be formed on the NMOS region RN, and the second gate stack G2 may be formed on the PMOS region RP. The first interfacial insulating film 121, the first high dielectric constant insulating film 131, the insertion layer 210, the first metal layer 141, the first protection layer 151, the first conductive film structure 161 and the first hard mask pattern 171 may be formed, which are sequentially stacked on the NMOS region RN. The second interfacial insulating film 122, the second high dielectric constant insulating film 132, the second metal layer 142, the second protection layer 152, the second conductive film structure 162 and the second hard mask pattern 172 may be formed, which are sequentially stacked on the PMOS region RP.

The first gate stack G1 may be formed by removing a portion of the stacked structure of the NMOS region RN, which does not overlap the gate mask MASK of FIG. 13, until the upper surface of the substrate 100 is exposed. The second gate stack G2 may be formed by removing a portion of the stacked structure of the PMOS region RP, which does not overlap the gate mask MASK of FIG. 13, until the upper surface of the substrate 100 is exposed.

For example, the first interfacial insulating film 121 of the NMOS region RN and the second interfacial insulating film 122 of the PMOS region RP may be formed by patterning the pre-interfacial insulating film 120p. The first high dielectric constant insulating film 131 of the NMOS region RN may be formed by patterning the pre-high dielectric constant insulating film 130p. The second high dielectric constant insulating film 132 of the PMOS region RP may be formed by patterning the pre-second high dielectric constant insulating film 132p.

The insertion layer 210 of the NMOS region RN may be formed by patterning the pre-insertion layer 210p. The first metal layer 141 of the NMOS region RN may be formed by patterning the pre-metal layer 140p. The second metal layer 142 of the PMOS region RP may be formed by patterning the pre-metal layer 140p.

The first protection layer 151 of the NMOS region RN may be formed by patterning the pre-protection layer 150p. The second protection layer 152 of the PMOS region RP may be formed by patterning the pre-protection layer 150p. The first lower conductive film 161a of the NMOS region RN may be formed by patterning the pre-lower conductive film 160ap. The second lower conductive film 162a of the PMOS region RP may be formed by patterning the pre-lower conductive film 160ap. The first insertion conductive film 161b of the NMOS region RN may be formed by patterning the pre-insertion conductive film 160bp. The second insertion conductive film 162b of the PMOS region RP may be formed by patterning the pre-insertion conductive film 160bp. The first upper conductive film 161c of the NMOS region RN may be formed by patterning the pre-upper conductive film 160cp. The second upper conductive film 162c of the PMOS region RP may be formed by patterning the pre-upper conductive film 160cp.

Next, referring to FIG. 1, the first gate spacer 181 may be formed on at least one side of the first gate stack G1. The second gate spacer 182 may be formed on at least one side of the second gate stack G2.

In concluding the detailed description, those skilled in the art will appreciate that many variations and modifications may be made to the embodiments without departing from the technical ideas and inventive concepts of the present disclosure. For example, in variants of FIG. 5, the buried gate electrode 111 may be in contact with the substrate 100 and the device isolation film 110 and/or the buried mask pattern 112 may be in contact with the substrate 100 and the device isolation film 110. The disclosed embodiments of the disclosure are used in a generic and descriptive sense only and not for purposes of limitation.

Embodiments are set out in the following clauses:
Clause 1. A semiconductor device comprising:
   a substrate including an NMOS region and a PMOS region;
   a first transistor in the NMOS region, including a first gate stack and a first source/drain region, wherein the first source/drain region is adjacent to at least one side of the first gate stack; and
   a second transistor in the PMOS region, including a second gate stack and a second source/drain region, wherein the second source/drain region is adjacent to at least one side of the second gate stack,
   wherein the first gate stack includes a first high dielectric constant insulating film, an insertion layer, a first metal layer and a first protection layer that are sequentially stacked in a first direction,
   the second gate stack includes a second high dielectric constant insulating film, a second metal layer and a second protection layer that are sequentially stacked in the first direction,
   an oxygen concentration of the first protection layer is higher than an oxygen concentration of the first metal layer, and
   an oxygen concentration of the second protection layer is higher than an oxygen concentration of the second metal layer.
Clause 2. The semiconductor device of clause 1, wherein a thickness of the first protection layer is smaller than a thickness of the first metal layer in the first direction, and
   a thickness of the second protection layer is smaller than a thickness of the second metal layer in the first direction.
Clause 3. The semiconductor device of clause 1 or 2, wherein a thickness of the first protection layer is equivalent to a thickness of the second protection layer in the first direction, and
   a thickness of the first metal layer is equivalent to a thickness of the second metal layer in the first direction.
Clause 4. The semiconductor device of any preceding clause, wherein a thickness of the first high dielectric constant insulating film is smaller than a thickness of the second high dielectric constant insulating film in the first direction.
Clause 5. The semiconductor device of any preceding clause, wherein the first protection layer comprises an oxide or an oxynitride of a first element, wherein the first element is the same as an element of the first metal layer, and
   the second protection layer comprises an oxide or an oxynitride of a second element, wherein the second element is the same as an element of the second metal layer.
Clause 6. The semiconductor device of any preceding clause, wherein a lanthanum (La) concentration in the second high dielectric constant insulating film is higher than a lanthanum (La) concentration in the first high dielectric constant insulating film.
Clause 7. The semiconductor device of any preceding clause, wherein a thickness of the first gate stack is greater than a thickness of the second gate stack in the first direction.
Clause 8. The semiconductor device of any preceding clause, wherein the first metal layer and the second metal layer respectively comprise at least one of titanium (Ti), aluminum (Al), tungsten (W), molybdenum (Mo) or lanthanum (La).
Clause 9. The semiconductor device of any preceding clause, wherein the first metal layer and the second metal layer comprise the same metal material.
Clause 10. A semiconductor device comprising:
   a substrate including a cell array region and a peripheral region, wherein the cell array region includes a buried gate structure and the peripheral region includes an NMOS region and a PMOS region with different conductivity types;
   a first transistor in the NMOS region, including a first gate stack and a first source/drain region, wherein the first source/drain region is adjacent to at least one side of the first gate stack; and
   a second transistor in the PMOS region, including a second gate stack and a second source/drain region, wherein the second source/drain region is adjacent to at least one side of the second gate stack,
   wherein the first gate stack includes a first high dielectric constant insulating film, an insertion layer, a first metal layer and a first protection layer that are sequentially stacked in a first direction,
   the second gate stack includes a second high dielectric constant insulating film, a second metal layer and a second protection layer that are sequentially stacked in the first direction,
   an oxygen concentration of the first protection layer is higher than an oxygen concentration of the first metal layer, and
   an oxygen concentration of the second protection layer is higher than an oxygen concentration of the second metal layer.
Clause 11. The semiconductor device of clause 10, wherein the first transistor further includes a first gate spacer on at least one side of the first gate stack, and
   the second transistor further includes a second gate spacer on at least one side of the second gate stack.
Clause 12. The semiconductor device of clause 10 or 11, wherein a lanthanum (La) concentration in the second high dielectric constant insulating film is higher than a lanthanum (La) concentration in the first high dielectric constant insulating film.
Clause 13. The semiconductor device of any one of clauses 10 to 12, wherein a thickness of the first protection layer is smaller than a thickness of the first metal layer in the first direction, and
   a thickness of the second protection layer is smaller than a thickness of the second metal layer in the first direction.
Clause 14. The semiconductor device of any one of clauses 10 to 13, wherein the first protection layer comprises an oxide or an oxynitride of a first element, wherein the first element is the same as an element of the first metal layer, and
   the second protection layer comprises an oxide or an oxynitride of a second element, wherein the second element is the same as an element of the second metal layer.
Clause 15. A semiconductor device comprising:
   a substrate including an NMOS region and a PMOS region;
   a first transistor in the NMOS region, including a first gate stack and a first source/drain region, wherein the first source/drain region is adjacent to at least one side of the first gate stack; and
   a second transistor in the PMOS region, including a second gate stack and a second source/drain region, wherein the second source/drain region is adjacent to at least one side of the second gate stack,
   wherein the first gate stack includes a first high dielectric constant insulating film, an insertion layer, a first metal layer and a first protection layer that are sequentially stacked in a first direction,
   the second gate stack includes a second high dielectric constant insulating film, a second metal layer and a second protection layer that are sequentially stacked in the first direction,
   an oxygen concentration of the first protection layer is higher than an oxygen concentration of the first metal layer,
   an oxygen concentration of the second protection layer is higher than an oxygen concentration of the second metal layer, and
      a lanthanum (La) concentration in the first high dielectric constant insulating film is higher than a lanthanum (La) concentration in the second high dielectric constant insulating film.

## Claims

1. A semiconductor device comprising:
a substrate (100) including an NMOS region (RN) and a PMOS region (RP);
a first transistor in the NMOS region (RN), including a first gate stack (G1) and a first source/drain region (105), wherein the first source/drain region (105) is adjacent to at least one side of the first gate stack (G1); and
a second transistor in the PMOS region (RP), including a second gate stack (G2) and a second source/drain region (107), wherein the second source/drain region (107) is adjacent to at least one side of the second gate stack (G2),
wherein the first gate stack (G1) includes a first high dielectric constant insulating film (131), an insertion layer (210), a first metal layer (141) and a first protection layer (151) that are sequentially stacked in a first direction (DR3),
the second gate stack (G1) includes a second high dielectric constant insulating film (132), a second metal layer (142) and a second protection layer (152) that are sequentially stacked in the first direction (D3),
an oxygen concentration of the first protection layer (151) is higher than an oxygen concentration of the first metal layer (141), and
an oxygen concentration of the second protection layer (152) is higher than an oxygen concentration of the second metal layer (142).

2. The semiconductor device of claim 1, wherein a thickness (T1) of the first protection layer (151) is smaller than a thickness (T2) of the first metal layer (141) in the first direction (D3), and
a thickness (T4) of the second protection layer (152) is smaller than a thickness (T5) of the second metal layer (142) in the first direction (D3).

3. The semiconductor device of claim 1 or 2, wherein a thickness (T1) of the first protection layer (151) is equivalent to a thickness (T4) of the second protection layer (152) in the first direction (D3), and
a thickness (T2) of the first metal layer (141) is equivalent to a thickness (T5) of the second metal layer (142) in the first direction (D3).

4. The semiconductor device of any preceding claim, wherein a thickness (T3) of the first high dielectric constant insulating film (131) is smaller than a thickness (T6) of the second high dielectric constant insulating film (132) in the first direction (D3).

5. The semiconductor device of any preceding claim, wherein the first protection layer (151) comprises an oxide or an oxynitride of a first element, wherein the first element is the same as an element of the first metal layer (141), and
the second protection layer (152) comprises an oxide or an oxynitride of a second element, wherein the second element is the same as an element of the second metal layer (142).

6. The semiconductor device of any preceding claim, wherein a lanthanum (La) concentration in the second high dielectric constant insulating film (132) is higher than a lanthanum (La) concentration in the first high dielectric constant insulating film (131) or wherein a lanthanum (La) concentration in the first high dielectric constant insulating film (131) is higher than a lanthanum (La) concentration in the second high dielectric constant insulating film (132).

7. The semiconductor device of any preceding claim, wherein a thickness (H1) of the first gate stack (G1) is greater than a thickness (H2) of the second gate stack (G2) in the first direction (D3).

8. The semiconductor device of any preceding claim, wherein the first metal layer (141) and the second metal layer (142) respectively comprise at least one of titanium (Ti), aluminum (Al), tungsten (W), molybdenum (Mo) or lanthanum (La).

9. The semiconductor device of any preceding claim, wherein the first metal layer (141) and the second metal layer (142) comprise the same metal material.

10. The semiconductor device of any preceding claim, wherein the substrate (100) includes a cell array region (R1) and a peripheral region (R2), wherein the cell array region (R1) includes a buried gate structure (114), and wherein the peripheral region (R2) includes the NMOS region (RN) and the PMOS region (RP).

11. The semiconductor device of any preceding claim, wherein the first transistor further includes a first gate spacer (181) on at least one side of the first gate stack (G1), and
the second transistor further includes a second gate spacer (182) on at least one side of the second gate stack (G2).

12. The semiconductor device of any preceding claim, wherein the insertion layer (210) contains lanthanum (La).

13. The semiconductor device of any preceding claim, wherein the first high dielectric constant insulating film (131) does not contain lanthanum (La), and the second high dielectric constant insulating film (132) contains lanthanum (La).
